# EUROPEAN PATENT APPLICATION

(11) **EP 1 777 317 A1**
(43) Date of publication of application: **25.04.2007**
(21) Application number: 06255419.1
(22) Date of filing: 20.10.2006
(51) Int. Cl.: C23C 4/04

(54) **Corrosion resistant member**

(30) Priority: 21.10.2005 JP 2005307190
(71) Applicant: Shin-Etsu Chemical Co., Ltd., Chiyoda-ku, Tokyo (JP)
(72) Inventor: Tsukatani, Toshihiko, Chiyoda-ku Tokyo (JP); Nakano, Hjime, Chiyoda-ku Tokyo (JP); Maeda, Takao, Chiyoda-ku Tokyo (JP)
(74) Representative: Stoner, Gerard Patrick

(57) **Abstract**

When a corrosion resistant member is exposed to a chlorine-containing gas or plasma thereof and then to the ambient atmosphere, the member surface does not absorb moisture. The surface of the member to be exposed to a chlorine-containing gas or a plasma thereof does not form chloride particles of substrate material. After washing of the member with water, the wash water exhibits no corrosive nature to the substrate. The member is free of damages to the substrate and of a loss of corrosion resistant capability.

## Description

### TECHNICAL FIELD

This invention relates to a corrosion resistant member whose surface state is kept unchanged even after use in a chlorine-containing gas or plasma thereof, and more particularly, to a corrosion resistant member which has corrosion resistance to a chlorine-containing gas or plasma thereof and is suitable for use in semiconductor manufacturing apparatus and flat panel display manufacturing apparatus.

### BACKGROUND ART

A halogen-containing corrosive gas atmosphere prevails in most semiconductor manufacturing apparatus, and flat panel display manufacturing apparatus such as liquid crystal, organic EL and inorganic EL manufacturing apparatus. Apparatus components are made of high purity materials in order to prevent workpieces from impurity contamination and defects due to particles. For these components, the surface purity and the surface state are paramount.

The semiconductor manufacturing process employs gate etching systems, insulating film etching systems, metal etching systems, resist film ashing systems, sputtering systems, CVD systems and the like. On the other hand, the liquid crystal manufacturing process employs etching systems for forming thin-film transistors and the like. In these processing systems, a plasma-producing mechanism is incorporated for microprocessing to a high degree of integration.

In these processing steps, especially in gate etching systems and metal etching systems, chlorine-containing corrosive gases are used as the processing gas due to their reactivity. Typical chlorine-containing gases include Cl₂, BCl₃, HCl, CCl₄, CHCl₃, SiCl₄, etc. When microwave or high frequency is applied to an atmosphere into which such gases or a gas mixture containing such gases has been fed, the gases are activated to a plasma. System members which are exposed to such chlorine-containing gases or plasma thereof are required to be highly corrosion resistant, that is, be least reactive with corrosive gases so that no particles of the reaction products of corrosive gases with the surface material form.

In view of the above requirement, the materials used in the art to impart corrosion resistance to chlorine-containing gas or plasma thereof include ceramics such as quartz, alumina, silicon nitride, and aluminum nitride, anodized aluminum (alumite) coatings, and substrates having coatings of the foregoing ceramics thermally sprayed on their surface.

However, the ceramic members suffer from the problem that particles are left on the surface. When the ceramic members are exposed to a plasma in a corrosive gas atmosphere, corrosion proceeds gradually, though to a varying extent depending on the identity of ceramic material. As a result, crystal grains lying in the surface region spall off, causing the so-called "particle contamination." When the aluminum base materials such as alumina, aluminum nitride and anodized aluminum coatings are exposed to chlorine-containing corrosive gas or plasma thereof, aluminum is etched with chlorine, creating particles. Alternatively, when the chamber which has been used in the process is opened to the ambient atmosphere (air), aluminum chloride on the aluminum base material absorbs moisture, which promotes the progress of material corrosion and the growth of aluminum chloride particles. Once spalling off, the particles deposit in proximity to the semiconductor wafer, lower electrode or the like, adversely affecting the etching precision and the like and detracting from the performance and reliability of the semiconductor.

Also, JP-A 2001-164354 describes yttrium oxide as a halogen plasma corrosion resistant material and empirically reports the corrosion resistance of the material against a fluorine plasma. When a surface of yttrium oxide is exposed to a chlorine plasma, however, there is produced deliquescent yttrium chloride.

As the current semiconductor technology is stepping forward targeting a finer feature size and a larger wafer diameter, the so-called dry process, especially etching process, has started using a low-pressure high-density plasma. As compared with conventional etching conditions, the low-pressure high-density plasma has significant impact on plasma-resistant members, giving rise to outstanding problems including erosion by the plasma, contamination of the members caused by the erosion, and contamination with reaction products of member material and surface impurities.

During the plasma etching step in the flat panel display manufacturing process, the substrates can react with the chlorine-containing gas in the plasma gas, forming chlorides which deposit as fines on the display. As substrates are increased in size in order to manufacture larger size flat panel displays, it becomes more important for reduced rejection rates to prevent particle generation and contamination.

### DISCLOSURE OF THE INVENTION

In a preferred aspect the invention provides a corrosion resistant member having a surface to be exposed to a chlorine-containing corrosive gas, which surface is fully resistant to exposure to a chlorine-containing gas or plasma thereof, undergoes no loss of corrosion resistance upon periodic washing, and is free of contaminants.

With respect to a member having a surface to be exposed to a chlorine-containing gas, the inventors have found that if no chloride particles form on the member surface when the member surface is exposed to a chlorine-containing gas or a plasma thereof, then no particle deposition occurs on semiconductor wafers, suggesting that the member is useful in semiconductor and flat panel display manufacturing apparatus. In contrast to the fact that when an aluminum based material is used to form a surface to be exposed to the corrosive gas, deliquescent aluminum chloride forms, with which substrates of corrosion resistant material can be corroded during aqueous washing, the inventors have found that if the member surface does not absorb moisture or form chloride particles when exposed to the ambient atmosphere, then the corrosion resistant member is not corroded during washing or does not undergo a loss of corrosion resistant capability by damages during repeated washing.

In a preferred embodiment the present invention provides a corrosion resistant member having a surface to be exposed to a chlorine-containing gas or plasma thereof, wherein when the member surface is exposed to a chlorine-containing gas or plasma thereof and then to the ambient atmosphere, the member surface does not absorb moisture.

In a preferred embodiment, the chlorine-containing gas is Cl₂, a gas mixture containing Cl₂, or a gas mixture containing the chlorine-containing gas.

In a preferred embodiment, the member comprises a rare earth fluoride. The rare earth is desirably at least one element selected from the group consisting of Y, Sc, La, Ce, Pr, Nd, Sm, Eu, Gd, Tb, Dy, Ho, Er, Tm, Yb, and Lu.

In a preferred embodiment, when the member surface is exposed to a chlorine-containing gas or plasma thereof and then to the ambient atmosphere, no chlorine compounds form on the member surface.

In a preferred embodiment, when the member is washed with water, the wash water exhibits no corrosive nature.

In a preferred embodiment, after the member surface is exposed to a chlorine-containing gas or plasma thereof, the member has a surface roughness Ra of up to 10 µm.

Typically, the corrosion resistant member is used in a semiconductor or flat panel display manufacturing apparatus.

Typically, the corrosion resistant member comprises a rare earth fluoride and is used in a chlorine-containing gas or a chlorine-containing gas plasma.

### BENEFITS OF PREFERRED EMBODIMENTS OF THE INVENTION

The corrosion resistant member of the invention, when its surface is exposed to a chlorine-containing gas or a plasma thereof and then to the ambient atmosphere (air), preferably has at least one of the advantages that (i) no moisture absorption occurs upon air exposure, (ii) no chloride compounds form upon air exposure, (iii) when the member is later washed with water, the wash water exhibits no corrosive nature, and (iv) the member has a surface roughness Ra of up to 10 µm.

The surface of the member to be exposed to a chlorine-containing gas or a plasma thereof preferably does not form chloride particles of substrate material. After washing of the member with water, the wash water preferably exhibits no corrosive nature to the substrate. As a result, the member is preferably free of damages to the substrate and also of a loss of corrosion resistant capability.

### BRIEF DESCRIPTION OF THE DRAWINGS

FIG. 1 is a photomicrograph under SEM (200×) of a yttrium fluoride surface on a sprayed sample in Example 1 after plasma exposure.
FIG. 2 is a photomicrograph under SEM (200×) of an alumite surface on a sample in Comparative Example 2, showing formation of aluminum chloride particles.

### DESCRIPTION OF THE PREFERRED EMBODIMENTS

The corrosion resistant member of the invention preferably comprises a substrate having an outermost surface to be exposed to a chlorine-containing gas or a plasma thereof wherein at least the outermost surface is formed by a rare earth fluoride layer.

The substrate may be selected from among metals, metal alloys, and ceramics, and more specifically from among A1, Mo, Ta, W, Hf, V, Zr, Nb, Ti, stainless steel (SUS), quartz, silicon nitride, alumina, and zirconia.

The chlorine-containing gas as used herein refers to Cl₂, BCl₃, HCl, CCl₄, CHCl₃, SiCl₄ or gas mixtures containing at least one of the foregoing.

The rare earth used in at least the surface layer of the corrosion resistant member is preferably selected from among Y, Sc, La, Ce, Pr, Nd, Sm, Eu, Gd, Tb, Dy, Ho, Er, Tm, Yb and Lu, and mixtures thereof, and more preferably from among Y, Sc, Gd, Tb, Dy, Ho, Er, Tm, Yb and Lu, and mixtures thereof. The fluorides of these rare earth elements may be used alone or in a combination of two or more. In the practice of the invention, fluorides of high purity is advantageously used in order to prevent alkali metals from precipitating.

The fluoride layer may be a thermally sprayed coating, a sintered layer, a physically deposited coating, a chemically deposited coating or the like, with the sprayed coating being preferred. Fluorides of some particular rare earth elements have a phase transition point. Specifically, since fluorides of Y, Sm, Eu, Gd, Er, Tm, Yb and Lu undergo expansion or contraction due to a phase change upon cooling from the sintering temperature, it is difficult to produce a sintered layer thereof. For forming fluoride layers of these elements, the thermal spraying process is especially preferred. The thermal spraying process enables formation of a dense coating because a coating sprayed on a substrate is quenched so that high-temperature phases are locally left.

As a general rule, corrosion resistant films can be deposited on substrates by a number of processes including physical deposition processes such as sputtering, evaporation, and ion plating; chemical deposition processes such as plasma CVD and pyrolytic CVD; and wet coating processes such as sol-gel process and slurry coating. In an attempt to manufacture the corrosion resistant member of the invention by such deposition processes, problems arise because the coating should preferably be relatively thick, specifically as thick as 1 µm or greater, and highly crystalline. The physical and chemical deposition processes are uneconomical because an extremely long time is necessary until the desired thickness is reached. Additionally, these processes need a vacuum atmosphere, which also becomes an uneconomical factor. As semiconductor wafers and glass substrates currently become large-sized, members in the manufacturing apparatus are also increased in size. Thus large-size vacuum pump units are necessary to deposit coatings on such large-size members.

On the other hand, the chemical deposition processes such as CVD, sol-gel process and the like also encounter the problem of enlarged manufacturing apparatus and require high-temperature heating to produce highly crystalline coatings. Then a choice of substrates that can be coated by these processes is limited. It is difficult to deposit coatings on resin and other materials which are less heat resistant than ceramic and metal materials.

JP-A 2002-293630 discloses a method of fluorinating a IIIA group element-containing ceramic material for modifying the surface to a IIIA group element fluoride. This method imposes a limit on the choice of substrate material because the substrate must contain the IIIA group element. The method is difficult to form a surface layer as thick as 1 µm or greater.

For the above-discussed reason, the invention favors a process which can deposit a coating with a thickness of 1 to 1,000 µm at a relatively high rate, can form a highly crystalline coating, and imposes little limits on the material and size of substrates. Desired from this point of view are a thermal spray process involving melting or softening a material and depositing molten droplets on a substrate until a coating is built up, and a cold spraying or aerosol deposition process involving impinging solid microparticulates against a substrate at a high speed for deposition. The thermal spray process uses argon or helium gas as the plasma gas. By mixing hydrogen gas with the inert gas, the plasma temperature and the plasma gas velocity are increased so that a higher density coating can be formed. Mixing 1 to 40% by volume of hydrogen gas is effective in forming a dense, less reactive coating. Specifically, spraying under these conditions results in a dense coating having a porosity of up to 10% as measured by image analysis. Such a dense coating provides a coating having more corrosion resistance and controlled particle release.

With respect to the coating thickness, no problems arise as long as the coating has a thickness of at least 1 µm. The coating generally has a thickness of 1 to 1,000 µm. A thickness of 10 to 500 µm is preferred for the coated member to have a longer lifetime since corrosion is not always nil.

The rare earth fluoride layer may contain sodium fluoride and potassium fluoride as impurities, preferably in an amount equal to or less than 100 ppm, more preferably equal to or less than 50 ppm of metallic sodium and potassium combined. Sodium fluoride has a solubility of 4.03 g in 100 g of water at 25°C, and potassium fluoride has a solubility of 92.3 g in 100 g of water at 18°C and deliquescence. If the content of sodium fluoride and potassium fluoride impurities is above 100 ppm, they can be leached out to create pores and generate particles during washing of the corrosion resistant (rare earth fluoride-coated) member. This undesirably forces the surface degradation of the corrosion resistant member.

The semiconductor manufacturing process involves dry etching steps where etching of polysilicon gate electrodes uses a plasma of a gas mixture containing one or more of CCl₄, CF₄ CHF₃, and NF₃: etching of aluminum interconnects uses a plasma of a gas mixture containing one or more of CCl₄, BCl₃, SiCl₄, BBr₃, and HBr; etching of tungsten interconnects uses a plasma of a gas mixture containing one or more of CF₄, CCl₄, and O₂. In the CVD process, silicon film formation uses a gas mixture of SiH₂Cl₂/H₂ or the like, Si₃N₄ formation uses a gas mixture of SiH₂Cl₂/NH₃/H₂ or the like, and TiN film formation uses a gas mixture of TiCl₄/NH₃ or the like. In the prior art, ceramics such as quartz, alumina, silicon nitride and aluminum nitride and anodized aluminum (alumite) coatings used to provide the surface to be exposed to the above-described gas or plasma have insufficient corrosion resistance, allowing the corrosion resistant material to be etched. This results in spalling off of ceramic grains, exposure of aluminum surface due to degradation of alumite coating, or formation of aluminum chloride particles. If spalling grains and aluminum chloride particles are introduced to wafers, they cause product defectives. The presence of such chloride on the corrosion resistant material surface can be ascertained by observing the corrosion resistant member surface after the member used in the plasma process is opened to the ambient atmosphere.

In the case of alumina, aluminum nitride and alumite-coated members which are exposed to a chlorine-containing gas or plasma thereof and then to the air, an observation of their surface reveals moisture absorption and bubbling as a result of the chloride thereon being exposed to the air. Alternatively, when the member surface after the plasma process is analyzed by energy dispersive x-ray spectrometry, chloride particles are observable. On the member surface, spherical aluminum chloride with a particle size of 1 to 100 µm is observed. Examination of the member surface for smoothness shows a surface roughness Ra in excess of 10 µm due to the aluminum chloride particles formed on the surface, proving a likelihood of particle formation. Then it is desired in the present invention that the member have a surface roughness Ra equal to or less than 10 µm, especially from the initial matrix state before the coating treatment. After its use in the plasma process, the member is usually washed with deionized water for removing deposits from the surface. If aluminum chloride which is highly soluble in water is on the member surface, it is readily dissolved in wash water, with which substrates of aluminum alloy or stainless steel can be corroded, resulting in the members having a shortened life. Corrosion resistant materials having insufficient corrosion resistance tend to lose surface smoothness during washing after plasma process use, that is, provide a substantial surface roughness. It is noted that the surface roughness is expressed by Ra according to the JIS standards. As the surface roughness increases, a likelihood of particles spalling off increases in a corrosive gas atmosphere. As the surface roughness increases, the area available for exposure to the corrosive gas increases, the amount of chloride reaction products formed increases, and the corrosion of substrates during deionized water washing is enhanced.

In contrast, the use of a rare earth fluoride layer as a surface to be exposed to a chlorine-containing gas or plasma thereof prevents formation of rare earth chlorides because the layer is stable due to a greater bond energy between rare earth and F than between rare earth and Cl. The rare earth fluoride itself is substantially insoluble in water, the wash water is not endowed with corrosive nature. In this way, the invention overcomes the above-discussed problems.

### EXAMPLE

Examples of the invention are given below by way of illustration and not by way of limitation.

### Example 1

An aluminum alloy substrate of 20 mm by 20 mm at its surface was degreased with acetone and roughened with corundum abrasives. By using an atmospheric plasma spraying equipment and feeding a gas mixture of argon gas and hydrogen gas in a volume ratio of 9:1 as a plasma gas, yttrium fluoride powder was sprayed onto the substrate at a power of 40 kW, a spray distance of 100 mm, and a rate of 30 µm/pass to form a coating of 200 µm thick.

The sprayed coating surface was examined for sodium and potassium by glow-discharge mass spectrometry using a glow-discharge mass spectrometer model VG9000 (Thermo Electron Corp.), finding 2 ppm of sodium and 1 ppm of potassium. A reflection electron image in cross section of the sprayed coating was analyzed and made binary by image analysis software Scion Image, from which a porosity of 2.8% was computed as a proportion of pore surface area relative to the overall surface area.

The spray coated sample was masked with polyimide tape to leave open a central area of 10 mm by 10 mm and exposed for 10 hours to a plasma atmosphere created by a reactive ion etching system RIE-10NR (Samco, Inc.) at an RF power of 500 W, a flow rate of 5 seem Cl₂ gas, and a pressure of 5 Pa. After the test, the chamber was opened to the air whereupon the surface of the sample was inspected for moisture absorption by visual observation. After the inspection, the sample was dried in vacuum and examined for the presence of chloride by observing under an energy dispersive x-ray spectrometer JED-2140 (Nippon Electron Co., Ltd.) over 10 fields at a magnification of 200×. Additionally, the surface roughness Ra of the sample before and after the plasma atmosphere exposure was measured according to JIS B-0601. The test results are shown in Table 1. The member surface exposed to the plasma atmosphere was washed twice with deionized water, after which the wash water was analyzed to find that no chlorides were leached out.

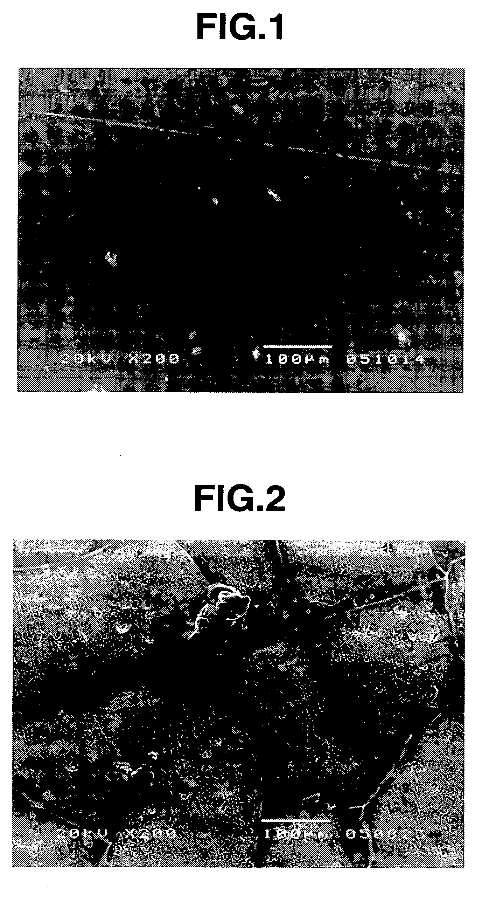

FIG. 1 is a photomicrograph under SEM (200×) of the yttrium fluoride surface on the sprayed sample after the plasma exposure test, showing the absence of chloride.

### Example 2

Thermal spraying and evaluation were performed as in Example 1 aside from using dysprosium fluoride as the spray powder. The results are also shown in Table 1. The sprayed coating surface had 3 ppm of sodium and 2 ppm of potassium. The porosity was 4.5%.

### Example 3

Thermal spraying and evaluation were performed as in Example 1 aside from using gadolinium fluoride as the spray powder. The results are also shown in Table 1. The sprayed coating surface had 2 ppm of sodium and 3 ppm of potassium. The porosity was 3.3%.

### Example 4

Thermal spraying and evaluation were performed as in Example 1 aside from using a powder mixture of 80 wt% yttrium fluoride and 20 wt% dysprosium fluoride as the spray powder. The results are also shown in Table 1. The sprayed coating surface had 1 ppm of sodium and 4 ppm of potassium. The porosity was 3.7%.

### Comparative Example 1

Thermal spraying and evaluation were performed as in Example 1 aside from using yttrium oxide as the spray powder. The results are also shown in Table 1.

### Comparative Example 2

An aluminum alloy A6061 substrate was anodized to form an alumite coating, followed by exposure to a plasma atmosphere as in Example 1 and evaluation as in Example 1. The results are also shown in Table 1.

FIG. 2 is a photomicrograph under SEM (200x) of the alumite surface on this sample, showing formation of aluminum chloride particles.

### Comparative Example 3

99.5% alumina ceramic was exposed to a plasma atmosphere as in Example 1 and evaluated as in Example 1. The results are also shown in Table 1.

### Comparative Example 4

Quartz was exposed to a plasma atmosphere as in Example 1 and evaluated as in Example 1. The results are also shown in Table 1.

**Table 1**

| | Surface layer | Gas species | Moisture absorption | Chloride by SEM-EDS analysis | Etching rate (nm/min) | Ra (µm), before/after plasma exposure |
|---|---|---|---|---|---|---|
| Example 1 | yttrium fluoride | Cl₂ | nil | nil | 0.3 | 0.06/0.09 |
| Example 2 | dysprosium fluoride | Cl₂ | nil | nil | 0.2 | 0.07/0.08 |
| Example 3 | gadolinium fluoride | Cl₂ | nil | nil | 0.4 | 0.06/0.08 |
| Example 4 | yttrium fluoride + dysprosium fluoride | Cl₂ | nil | nil | 0.6 | 0.08/0.15 |
| Comparative Example 1 | yttrium oxide | Cl₂ | absorbed | found | 0.3 | 0.13/12.52 |
| Comparative Example 2 | alumite | Cl₂ | absorbed | found | 6.6 | 0.63/15.83 |
| Comparative Example 3 | alumina* | Cl₂ | absorbed | found | 0.7 | 0.08/14.52 |
| Comparative Example 4 | quartz* | Cl₂ | absorbed | found | 17.6 | 0.11/0.57 |

| | | | | | | |
|---|---|---|---|---|---|---|
| ***** substrate | | | | | | |

It is seen from the data that the use of rare earth fluoride as a surface to be exposed to a chlorine-containing gas or plasma thereof prevents formation of chloride or chloride particles which will absorb moisture after the chamber is opened to the ambient air. The member with a rare earth fluoride surface layer has sufficient corrosion resistance to minimize particle contamination on wafers and to prevent its substrate from corrosion with chlorine solution during washing.

## Claims

1. A corrosion resistant member having a surface to be exposed to a chlorine-containing gas or a chlorine-containing gas plasma, wherein when the member surface is exposed to a chlorine-containing gas or a chlorine-containing gas plasma and then to the ambient atmosphere, the member surface does not absorb moisture.

2. The corrosion resistant member of claim 1 wherein the chlorine-containing gas is Cl₂, a gas mixture containing Cl₂, or a gas mixture containing the chlorine-containing gas.

3. The corrosion resistant member of claim 1 or 2 wherein the member comprises a rare earth fluoride.

4. The corrosion resistant member of claim 3 wherein the rare earth is at least one element selected from the group consisting of Y, Sc, La, Ce, Pr, Nd, Sm, Eu, Gd, Tb, Dy, Ho, Er, Tm, Yb, and Lu.

5. The corrosion resistant member of any one of claims 1 to 4 wherein when the member surface is exposed to a chlorine-containing gas or a chlorine-containing gas plasma and then to the ambient atmosphere, no chlorine compounds form on the member surface.

6. The corrosion resistant member of any one of claims 1 to 5 wherein when the member is washed with water, the wash water exhibits no corrosive nature.

7. The corrosion resistant member of any one of claims 1 to 6 wherein after the member surface is exposed to a chlorine-containing gas or a chlorine-containing gas plasma, the member has a surface roughness Ra of up to 10 µm*.*

8. The corrosion resistant member of any one of claims 1 to 7 which is used in a semiconductor or flat panel display manufacturing apparatus.

9. The corrosion resistant member of claim 8 wherein the member comprises a rare earth fluoride and is used in a chlorine-containing gas or a chlorine-containing gas plasma.

10. Use of a corrosion resistant member according to any one of claims 1 to 7 for providing resistance to a chlorine-containing gas or a chlorine-containing gas plasma.
